Europäisches Patentamt

European Patent Office

Office européen des brevets

(11) Numéro de publication : **0 424 262 B1**

(12) **FASCICULE DE BREVET EUROPEEN**

(19)

⑪

(45) Date de publication du fascicule du brevet :
**17.06.92 Bulletin 92/25**

(51) Int. Cl.⁵ : **H01R 9/09,** H05K 3/34

(21) Numéro de dépôt : **90402931.1**

(22) Date de dépôt : **18.10.90**

(54) **Electronique portable connectable à puces.**

(30) Priorité : **20.10.89 FR 8913755**

(43) Date de publication de la demande :
**24.04.91 Bulletin 91/17**

(45) Mention de la délivrance du brevet :
**17.06.92 Bulletin 92/25**

(84) Etats contractants désignés :
**DE GB IT**

(56) Documents cités :
**DE-A- 3 231 056**
**FR-A- 2 619 276**
**GB-A- 2 134 338**
**GB-A- 2 202 094**
**US-A- 4 642 889**
**US-A- 4 688 150**

(73) Titulaire : **SGS-THOMSON**
**MICROELECTRONICS S.A.**
**7, Avenue Galliéni**
**F-94250 Gentilly (FR)**

(72) Inventeur : **Steffen, Francis, Cabinet**
**Ballot-Schmit**
**7, rue Le Sueur**
**F-75117 Paris (FR)**

(74) Mandataire : **Schmit, Christian Norbert Marie**
**et al**
**Cabinet Ballot-Schmit 7, rue Le Sueur**
**F-75116 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un système d'électronique portable connectable. Ce système est utilisable dans le domaine de l'électronique portable et connectable. Elle peut néanmoins servir dans le domaine de la réparation où le connecteur intégré ainsi inventé peut permettre une meilleure interchangeabilité des composants.

Les applications diverses nouvelles de la carte à puces montrent que cette carte est appelée à réaliser des fonctions de plus en plus complexes, si on veut étendre son domaine d'applications. Ceci conduit alors à la nécessité d'utiliser des surfaces de puces à intégrer dans ces cartes de plus en plus importantes, pour réaliser ces fonctions. Tel est le cas par exemple, des deux applications connues de la carte à puces que sont la carte téléphone et la carte bancaire. La puce de la carte téléphone est une simple mémoire. Elle occupe une surface de l'ordre du $mm^2$. La puce d'une carte bancaire est un processeur intégrant de la mémoire et l'application. Elle occupe une surface de l'ordre de $20mm^2$.

Rappelons brièvement qu'une carte à puces est une carte plastique relativement peu épaisse, dans laquelle sont encartées, dans l'épaisseur de la carte, une puce de semi-conducteurs et une grille de conducteurs. La puce est assemblée à une surface supérieure de la grille, par exemple par collage. Des fils conducteurs sont ensuite soudés d'une part aux bornes de sortie de la puce, d'autre part sur des métallisations de la grille. C'est la technologie d'assemblage de la carte à puces, dite de chip on board, dans la littérature anglo-saxonne. Une surface inférieure de la grille affleure l'une des deux surfaces de la carte et constitue le connecteur de la carte à puce. Quand cette carte est insérée dans le lecteur, c'est sur ce connecteur que vient se brancher le lecteur.

Mais le support classique de la carte à puces est mal adapté à une puce de grande surface. Si ce support est souple, la puce, elle, est en effet très rigide. Les brins conducteurs risquent de casser. Plus la puce est grande, plus elle est sensible aux déformations et plus on a de chances de l'abîmer. Ce qui a pour effet, en pratique de diminuer la fiabilité de la carte à puce, quand celle-ci intègre une grande puce. Ceci limite la possibilité d'étendre le domaine d'utilisation de la carte à puces, notamment aux applications nouvelles.

Diverses techniques connues ont été utilisées pour remédier à ce problème. On a notamment essayé de diminuer l'amplitude des déformations au niveau de la puce et des fils qui la relient à sa grille de connecteurs. On peut citer, par exemple, l'utilisation connue d'une dalle de cobalt placée sous le substrat de la puce, pour rigidifier la puce. Dans un autre exemple, on a modifié le procédé de réalisation d'une cavité dans la carte pour recevoir la puce afin de rigidifier l'environnement de la puce. Mais ces solutions ne permettent pourtant pas d'assembler, dans cette technologie d'assemblage de la carte à puces, des surfaces importantes : supérieures à $20mm^2$ par exemple. Et pour de telles surfaces, nombre de problèmes apparaissent, notamment celui de la fiabilité de la puce ainsi assemblée.

Par ailleurs, le matériau plastique qui constitue la carte n'est pas étanche aux diverses pollutions ioniques et organiques auxquelles sont très sensibles les puces de circuit intégré. La détérioration de la fiabilité induite est d'autant plus aggravée que la puce est grande. Ceci est une troisième limitation technologique.

La technologie d'assemblage utilisée est du type hybride. Elle n'est pas optimisée en terme de production. En effet, dans le cadre de l'assemblage de semi-conducteurs, on utilise une ligne standard d'un produit qui est fait en très gros volume. Ce produit est une ou plusieurs puces assemblées dans un boîtier standard est appelé un composant électronique. Ces puces sont ou non inter-connectées entre elles. A côté de ces composants électroniques produits en gros volume, on a donc un produit spécifique : C'est le cas par exemple, de la carte à puce. Or ce produit spécifique est produit dans un bien moins gros volume. Et il nécessite une ligne de production spécifique, elle aussi. Ce qui augmente considérablement les coûts de production et les frais d'amortissement de cette ligne, par rapport aux lignes de production de produits standards. De plus, le taux de rejet de ce produit spécifique est beaucoup plus élevé que celui des produits standards du fait de la technologie utilisée. En effet, dans la technologie de la carte à puces, la fixation des fils conducteurs est une opération délicate dont la fiabilité influe directement sur le produit final. Une protection spécifique de ces fils est nécessaire pour en garantir la non dégradation.

Pour éviter ces difficultés, on a par ailleurs tenté, dans une technologie dite de "tape automatic bonding", de relier en particulier par transfert à chaud, des queues de métallisations de la grille aux bornes de la puce. Cependant, cette technologie souffre aussi de la précision de fabrication qu'elle nécessite. Elle ne conduit pas non plus à une fiabilité d'assemblage suffisante.

L'invention a pour objet de remédier à ces inconvénients et de permettre l'évolution de la carte à puces vers des applications nouvelles plus complexes, et qui ne sont pas gênées et limitées par l'antécédence des lecteurs de cartes magnétiques, des applications qui utiliseraient par exemple une clef électronique, au sens de la fonction électronique et de la forme de l'objet.

Elle utilise les boîtiers électroniques munis de broches de connexion standards dans lesquels on intègre la fonction à réaliser : une ou plusieurs puces ;

on sait interconnecter plusieurs puces sur un circuit imprimé et intégrer le tout dans un boîtier standard. Le composant électronique obtenu, a une fiabilité bien supérieure à celle des puces, du fait du boîtier qui protège mécaniquement des diverses pollutions ioniques et organiques, la ou les puces du composant électronique. Du fait également de la technologie d'assemblage des puces dans un boîtier, qui est une technologie standard bien maîtrisée. On peut donc réaliser des fonctions complexes. Cependant, un tel composant n'est pas connectable au sens de l'invention : un composant par exemple pour assemblage par montage en surface a des broches trop fines pour que l'on ait un contact sûr et fiable sur le connecteur d'un lecteur. Un composant pour assemblage par insertion, lui non plus, ne peut pas être inséré des milliers de fois dans un connecteur : les broches vont se tordre ou même casser et de toute façon l'opération d'insertion est alors délicate.

L'invention a donc pour objet un système de connection, avec un lecteur, d'une puce électronique maintenue dans un support d'enrobage portable caractérisée en ce que cette puce est elle même contenue dans un boîtier du type composant électronique ayant des broches de sortie assemblables par un montage en surface, ce boîtier comportant à cet effet des broches à poser et à souder sur des contacts métalliques d'une surface supérieure d'un moyen de connexion, et en ce que ce système comporte un connecteur pour connecter la puce au lecteur, le connecteur étant constitué par des contacts métallique d'une surface inférieure du moyen de connexion, des contacts métalliques de la surface supérieure étant en vis-à-vis de et connectés à des contacts métalliques de la surface inférieure et réciproquement, ce moyen de connexion étant maintenu à fleur dudit support d'enrobage.

Les caractéristiques d'un système conforme à l'invention sont données dans la description qui suit et qui est faite en référence aux figures annexées. Cette description et ces figures ne sont faites qu'à titre indicatif et nullement limitatif de l'invention. Dans ces figures :

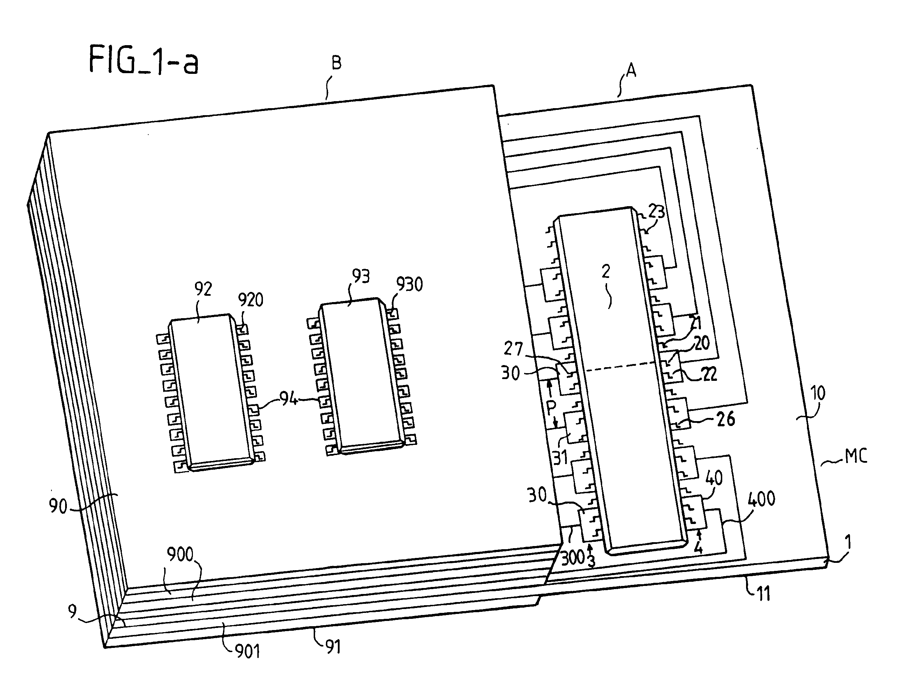

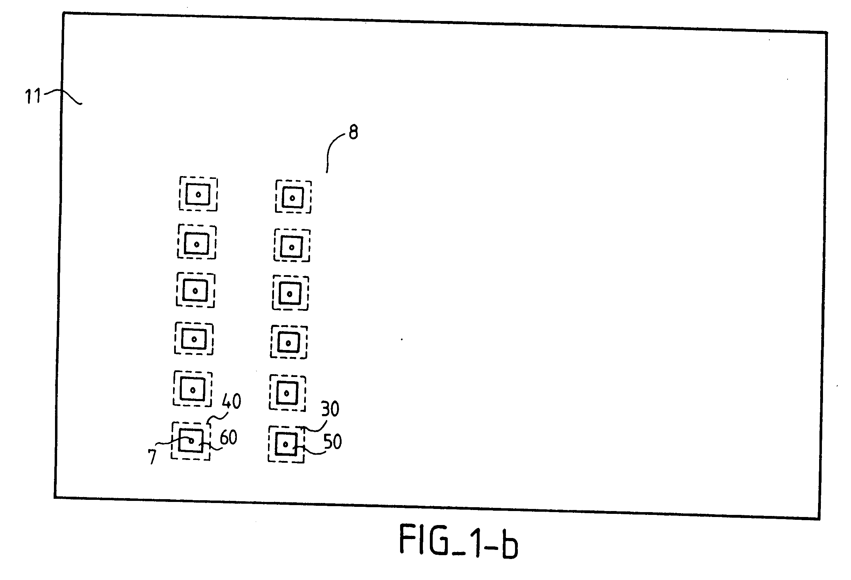

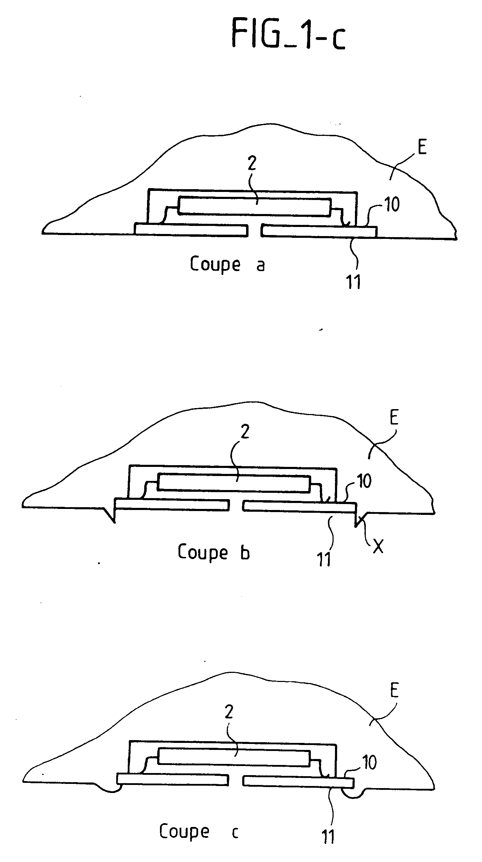

la figure 1a est une vue en perspective de la partie supérieure d'un système selon l'invention,

la figure 1b est une vue de dessus de la partie inférieure d'un système selon l'invention.

la figure 1c compte trois vues en coupe a, b, et c d'un module électronique connectable, selon diverses techniques d'enrobage.

La figure 1a est une vue en perspective d'un système selon l'invention. Dans la zone A, le système est constitué d'un moyen de connexion MC. Ce moyen de connexion comporte dans l'exemple un support isolant 1. Une face supérieure 10 du support isolant 1 comporte une première et une deuxième rangées 3 et 4 de contacts métalliques 30 et 40. Les deux rangées 3 et 4 sont parallèles. Les contacts métalliques 30 de la première rangée 3 sont alignés sur les contacts métalliques 40 de la deuxième rangée 4. Les deux rangées 3 et 4 ont un même nombre de contacts métalliques. Le pas de connexion P, qui est la distance inter-milieu de deux contacts consécutifs 30 et 31, est dans l'exemple le même pour les deux rangées. Les contacts métalliques 30 et 40 sont plans et par exemple rectangulaires. Un composant électronique 2 est fixé sur la face supérieure 10 du support isolant 1 par une technologie d'assemblage de montage en surface. Des broches 20, 21, 22 et 23 du composant électronique sont posées à leur extrémité libre sur des contacts métalliques (20, 22) ou sur le support isolant (21, 23). Elles sont fixées par exemple par soudure à chaud sur les contacts métalliques (broches 20, 22) et par collage sur le support isolant (broches 21, 23).

En vis-à-vis de chaque contact métallique 30 et 40 de la face supérieure 10, un contact métallique 50 et 60 se trouve sur la surface inférieure 11 du support isolant 1. (figure 1b). Deux contacts métalliques en vis-à-vis, par exemple 40 et 60, sont connectés par exemple (sur la figure 1b) par un trou métallisé 7.

L'ensemble des contacts métalliques 50 et 60 de la face inférieure 11 du support isolant 1 constitue le connecteur 8 du système. L'ensemble des contacts métalliques de chacune des surfaces supérieure et inférieure et le support isolant forment dans l'exemple, le moyen de connexion MC.

Les contacts métalliques 50 et 60 de la face inférieure 11 sont plans et dans l'exemple rectangulaires. Ces contacts métalliques 50 et 60 occupent chacun dans l'exemple une surface inférieure et comprise dans la surface occupée par le contact métallique 30 et 40 qui lui correspond sur la face supérieure : c'est à dire en vis-à-vis. Les surfaces des contacts pourraient être égales dans un autre exemple.

La réalisation pratique d'un tel support 1 avec des contacts métalliques 30, 50 qui se correspondent sur les surfaces supérieures 10 et inférieures 11 est par exemple la suivante : on perce des trous 7 dans un support isolant 1, aux emplacements des futurs contacts métalliques 30, 40. On applique sur les deux surfaces supérieures et inférieures du support isolant 1 du métal que l'on grave chimiquememnt selon des procédés bien connus, pour obtenir les contacts métalliques 30 et 50. Comme chaque trou 7 est compris dans chacune des surfaces des contacts métalliques qui se correspondent, 30 et 50, 40 et 60, il est métallisé et assure la connexion entre les deux plages 30 et 50, 40 et 60. Le support isolant 1 peut-être par exemple un film de polyimide, ou un circuit imprimé ou tout autre matériau isolant.

La forme des contacts métalliques 30 et 40 de la face supérieure 10 est imposée par le composant électronique 2. On a dit que le composant est assemblé par un montage en surface sur le support.

De manière connue (normes), pour que la fiabilité de l'assemblage soit optimale en terme de fabrication, il faut que les contacts métalliques 30 et 40 soient suffisamment larges. En effet, on doit pouvoir tolérer un composant mis de travers ou légèrement décalé par rapport aux contacts métalliques. Cette tolérance est liée aux machines d'assemblage automatique. Il y a aussi le pas de connexion minimal à respecter pour éviter les problèmes de perturbations électriques. Cette dernière contrainte influe également sur la forme des plages de contacts 50 et 60. Cette forme doit permettre la fiabilité maximale du contact avec le connecteur du lecteur.

De plus, il existe plusieurs standards de boîtiers pour les composants électroniques. Une fonction électronique donnée peut donc être proposée sous divers emballages catalogues : boîtier plastique, céramique, carré, rectangulaire, avec des broches sur deux rangées, ou des broches sur tout le pourtour du boîtier, un pas de connexion donné, des broches recourbées vers l'intérieur ou vers l'extérieur du boîtier et la liste n'est pas exhaustive.

On choisit donc sur la face supérieure 10 une forme et répartition des plages de connexion 30 conforme au type d'emballage (boîtier) et de connexion (sorties du boîtier) choisi. Dans l'exemple de la figure 1a, il s'agit d'un boîtier 24 rectangulaire avec des broches 26 réparties sur deux rangées, au nombre de 40.

Le choix d'un composant pour montage en surface est lié à l'utilisation du connecteur 8 du système. Rappelons que ce connecteur 8 est constitué des contacts métalliques 50 et 60 de la face inférieure 11 du support isolant 1 (figure 1b). Si on utilise un composant électronique pour montage en insertion, les broches de ce composant traversent le support 1 et dépassent de la face inférieure du support : on voit tout de suite les inconvénients que cela entraîne. D'une part au toucher, puisque la surface inférieure est parsemée des extrémités des broches. D'autre part pour l'insertion et la connexion dans un lecteur du système. Dans la suite , quand on parle de composant électronique, il est par défaut pour montage en surface.

On a vu qu'aux composants électroniques pour montage en surface standards, correspondent donc des plages de connexion dont la forme peut varier, rondes, rectangulaires..., mais dont le nombre et la répartition sont bien connues selon le type choisi du boîtier et donc de sa connexion : la connexion est ici adaptée à l'électronique.

Mais il existe par ailleurs des connecteurs normalisés ou non, tel celui d'une carte à puces, qui ne correspondent pas aux normes imposées par les emballages et connectiques standard des composants électroniques vus. Ceci, parce que ces connecteurs n'ont pas été définis pour de tels composants. Ces connecteurs sont définis pour le lecteur du système électronique portable et connectable. Ils sont définis en forme, nombre, répartition des plages connectiques, positionnement dans le lecteur... il est donc important de pouvoir utiliser ces lecteurs, parce qu'ils existent. Dans de tels cas, on va adapter alors l'électronique à la connexion.

Un bon exemple d'un lecteur existant est le lecteur d'une carte à puces, de type publiphone. Le connecteur bien connu d'une carte à puces est normalisé: le pas de connexion est de 2.54 mm ; il comporte deux rangées de 4 contacts métalliques ; les rangées sont espacées d'environ 8mm. Ce connecteur est sur la face inférieure du support. Sur la face supérieure, on a les contacts métalliques correspondantes en vis à vis. Mais la forme de chaque plage de la face supérieure peut être différente de celle des contacts métalliques du connecteur : plus large par exemple.

Un standard connu de composant électronique définit un pas de connexion de 1.27 mm. Si on choisit ce standard avec un boîtier de 16 broches, dont une broche sur deux est connectée à la fonction électronique intégrée dans le boîtier, on voit que le pas de connexion des broches connectées à la fonction électronique devient de 2.54 mm : il est possible d'assembler un tel composant sur un support dont le connecteur est celui d'une carte à puces. Les broches non connectées à la fonction électronique servent alors au maintien mécanique du composant électronique sur son support.

Pour adapter la largeur du boîtier et la forme des broches aux plages connectiques de la face supérieure du support, il suffit par exemple de faire des contacts métalliques plus larges vers l'intérieur des deux rangées pour un boîtier étroit ou pour des broches recourbées sous le boîtier. Pour un boîtier large ou pour des broches recourbées vers l'extérieur du boîtier, on fait par exemple le contraire : des contacts métalliques plus larges vers l'extérieur des rangées, qui vont déborder du boîtier.

C'est un exemple un peu différent que l'on a choisi de décrire sur la figure 1a. En effet dans l'exemple de la figure 1a, on a représenté un composant électronique 2, dont seulement une broche 20 sur trois broches successives 20, 21 et 22, est connectée à la fonction électronique intégrée dans le boîtier. Ceci pour montrer les diverses possibilité d'adaptation d'un assemblage d'un composant électronique à un type de connecteur donné, selon l'invention.

Dans cet exemple, le composant 2 est monté sur le support en sorte que chacune des broches de sorties des fonctions électroniques intégrées dans le boîtier 24 soit fixée sur un contact métallique 30 de la face supérieure 10. Il est clair que le nombre de broches de sorties électroniques est inférieur ou égal au nombre de contacts métalliques. Dans l'exemple, on a deux broches 20, 22 fixées sur une même plage conductrice. Mais seule une broche, 20, est une sortie électronique. Entre chaque contact métallique successif, une broche du boîtier est fixée au support isolant. Cette disposition est déduite du rapport des pas de connexion du connecteur et du composant.

Dans l'exemple, le boîtier est plus long que la surface de connexion sur le support. C'est pourquoi les broches 23 en dehors de la plage de connexion sont dans l'exemple fixées sur le support isolant. Dans l'exemple, la plage de connectique est l'ensemble des contacts métalliques sur une même surface.

On rappelle que les broches 21, 22 et 23 n'ont ici qu'une fonction de maintien mécanique du composant électronique 2 sur son support, comme celà a été dit dans la description. Il est clair que les broches qui sont des sorties électroniques sont de préférence en vis-à-vis sur les deux rangées, 3 et 4 telles que les broches 20 et 27 sur la figure 1a.

On a donc vu que l'on peut ainsi utiliser n'importe quel boîtier standard de composants électroniques pour montage en surface, le nombre de broches du boîtier et le type du boîtier, étant déterminés d'une part par la complexité de la ou des fonctions électroniques à intégrer, d'autre part par le nombre des sorties de ces fonctions et le type de connecteur 8 du système.

On peut ainsi réaliser une fonction électronique complexe ayant un petit nombre de sorties, par des puces intégrées dans des boîtiers qui les protègent mécaniquement et qui améliorent très sensiblement la fiabilité de la fonction électronique. Certaines broches peuvent ne servir qu'au maintien mécanique du composant électronique standard ainsi réalisé, sur son support.

Avantageusement, selon un second mode de réalisation représenté en coupe sur la figure 1c, le moyen de connexion ne comporte que des contacts métalliques : les contacts métalliques 30, 50 en vis à vis et connectés dans l'exemple précédent sont ici confondus : ils servent, du côté surface supérieure 10 du moyen de connexion MC, d'interconnexion avec le composant de montage en surface 2, et du côté surface inférieure (11) du moyen de connexion MC, de connecteur (8). Dans ce cas, il n'y a même plus de support isolant. Ceci est possible, car le composant est solide, rigide, et il n'y a pas de risques de pollution. On peut alors par exemple, monter le composant sur une grille de contacts court-circuités entre eux, puis découper ces contacts. Cette opération est simple et fiable. Les contacts métalliques peuvent être prévus assez épais pour augmenter la rigidité du module. Il est toujours possible de déposer de l'isolant sur les broches ou sous le composant, bien que cela n'ait plus, dans ce mode de réalisation d'un composant connectable, un caractère obligatoire. Comme dans le premier mode de réalisation, des broches du composant peuvent ne pas être connectées : elles ne sont pas des sorties électroniques du composant. Elles n'ont qu'un rôle mécanique. Elles facilitent alors l'accrochage par exemple d'un matériau plastique préalablement moulé qui réalise l'enrobage du composant connectable. Ces broches peuvent aussi être montées sur un contact métallique. Par exemple on peut avoir deux broches sur un même contact : une seule des broches est une sortie électronique dans ce cas, mais les deux broches augmentent la rigidité de la connexion.

Sur la figure 1c on a représenté un enrobage E du composant électronique 2 rendu connectable selon l'invention. Cet enrobage peut-être fait par un matériau diélectrique, dissipatif ou conducteur. Dans le cas où il est conducteur, il doit être prévu par exemple un isolant dans la cavité devant contenir le composant. Le composant peut très bien arriver à fleur de la surface externe du matériau d'enrobage. La forme du système enrobé peut-être quelconque, la seule contrainte étant d'avoir le connecteur (8) accessible par un lecteur. L'enrobage peut-être par exemple collé (coupe a) ou encore soudé par ultra-sons. Dans ce dernier cas, l'enrobage présente un excès de matière x (coupe b), au niveau des contacts, qui permet l'accrochage de l'enrobage sur les contacts, par ultra-sons : l'enrobage est riveté (coupe c). Cette dernière solution est en particulier interessante dans le cas d'un enrobage en matière dissipative (c'est à dire faiblement conductrice); les contacts et l'enrobage sont alors en effet sur une même équipotentielle, ce qui favorise l'absorption des charges électrostatiques émises proches des contacts. Le caractère dissipatif de l'enrobage permet aussi le fonctionnement normal du composant : les contacts ne sont alors plus court-circuités. On voit l'intérêt d'un tel enrobage qui permet à la fois le fonctionnement normal du circuit et la protection électrostatique.

On peut aussi avoir une autre partie électronique liée à celle que l'on vient de décrire. Un tel exemple est représenté sur la zone B de la figure 1a.

Dans la figure 1a, les contacts métalliques 30 et 40 de la face supérieure 10 du support 1 se prolongent par des fils conducteurs 300 et 400 vers la zone B. De préférence, les fils conducteurs 300 et 400 ne passent pas sous le boîtier 24 du composant électronique 2. Dans la zone B ils constituent une couche de connexion dans le support 9. Le support 9 est dans l'exemple multi-couches : il est composé de plusieurs couches de connexion 900 empilées et interconnectées entre elles. Sur la surface supérieure 90, des composants électroniques 92 et 93 sont montés en surface sur des contacts métalliques standards 94. Ces composants 92 et 93 sont par exemple interconnectés entre eux par les couches de connexion 900 du support 9. Ils sont aussi interconnectés avec le composant électronique 2 par la couche de connexion 901 portant les fils conducteurs 300, 400, qui prolongent les contacts métalliques 30 et 40.

Les composants électroniques 92 et 93 sont ici compatibles avec un montage en surface. Ce pourrait très bien être ici des composants pour montage en insertion. En effet dans l'exemple, ces composants n'ont pas à être connectable au sens de l'invention. Ils pourraient bien sûr l'être, par exemple si on voulait avoir , dans un même système, plusieurs fonctions électroniques indépendantes les unes des autres, et chacune connectable du sens de l'invention.

Les plages de connexion 94 sont standards par rapport au type des composants électroniques 92 et 93, puisqu'aucune contrainte extérieure de connexion n'est à prendre en compte. On pourrait très bien monter les composants 92 et 93 sur la surface inférieure 91 ou même sur les deux surfaces, inférieure 91 et supérieure 90, du support 9. On voit donc que de multiples combinaisons sont possibles. Par exemple la surface inférieure 11 et la surface inférieure 91 peuvent être les mêmes.

Le support 9 peut n'être composé que d'une couche de connexion qui comporte alors uniquement les fils conducteurs 300 et 400 : le support 9 peut alors tout simplement être le support 1.

Dans la zone A, les fils conducteurs 300, 400 sont dans l'exemple sur la surface supérieure 10 du support 1. Ils pourraient être dans un plan médian, c'est à dire parallèle et compris entre les faces inférieure 11 et supérieure 10 du support 1.

Il reste à enrober le système dans un matériau. La forme du système peut être quelconque, adaptée au lecteur. Les seules contraintes sont donc :

Tout d'abord, si le système n'est pas inséré complètement dans le lecteur, la partie non insérée ne doit pas comporter de connexions électriques non isolées électriquement. En effet, il y aurait, sinon, des pertubations électriques ou électrostatiques qui altèreraient le fonctionnement du système.

Ensuite, le connecteur 8 doit affleurer une surface du système, pour que le lecteur puisse se brancher dessus.

De plus, la forme du système doit permettre une insertion facile, partielle ou totale et une connexion fiable du lecteur sur le système.

Enfin, si le matériau d'enrobage n'est pas un diélectrique, il faut prévoir d'isoler toute la connexion du matériau d'enrobage.

Une forme possible bien connue est une carte. On peut aussi avoir une clef ou tout autre forme, pourvue qu'elle réponde aux critères énoncés ci-dessus.

Dans le système décrit, la fiabilité de l'électronique est considérablement améliorée par rapport à celle obtenue avec la technologie classique des cartes à puces. En effet un boîtier, par exemple plastique ou céramique, d'un composant électronique est rigide. Il est aussi étanche notamment aux diverses agressions ioniques et organiques. C'est lui qui améliore la fiabilité. En conclusion, dans l'invention, on a dès lors une fiabilité suffisante pour réaliser des applications complexes dans le domaine de l'électronique portable connectable, en particulier bancaires.

Ceci n'était pas envisageable avec la technologie classique de la carte à puces pour des raisons déjà expliquées.

Le choix du type de boîtier est aussi varié. Ce qui est important, c'est l'optimisation du coût de fabrication du module : en fonction de la densité d'intégration nécessaire pour l'application visée, du coût de fabrication et du taux de rejet dans chacune des diverses technologies.

L'aspect coût de fabrication est en effet très important dans le domaine des cartes à puces. L'objectif de prix d'achat des utilisateurs est en effet très faible. Pour cette raison, comme on l'a déjà vu, le coût de production et les frais d'amortissement induits par l'utilisation d'une chaîne de production spécifique dans la technologie classique des cartes à puces est un inconvénient majeur de cette technologie dans l'aspect coût de fabrication. A cela, s'ajoute le taux de rejet important, plus important que celui obtenu avec les technologies classiques de semiconducteurs. L'utilisation des composants électroniques remédie à l'ensemble de ces inconvénients. En effet, les lignes de production sont alors les lignes standard d'assemblage de semi-conducteurs. De plus, dans l'invention, quand les composants électroniques sont assemblés, par exemple sur un circuit imprimé, si le test final n'est pas bon, il est possible de dessouder un composant qui serait mauvais et de le remplacer par un autre, assemblé alors sur le même connecteur. Il est aussi possible de changer le circuit imprimé qui serait mauvais et de garder ainsi le composant : on ne perd pas l'ensemble du module. Ceci est un net avantage par rapport à la carte à puces: si elle n'est pas bonne, on ne peut rien récupérer.

En résumé, l'invention permet donc d'avoir un système d'électronique portable et connectable adaptée à toutes les applications nouvelles complexes. En particulier, tout système électronique comportant au moins un composant de montage en surface qui est ou non connecté à une autre électronique du système, et qui est connectable au sens de l'invention, c'est à dire monté en surface :

– soit sur des contacts métalliques en surface d'un support isolant, ces contacts étant en vis à vis et connectés à d'autres contacts métalliques de la surface opposée sur le support isolant et qui forment le connecteur,

– soit avantageusement sur des plaques métalliques faisant d'un côté l'interconnexion avec le composant et de l'autre côté opposé, le connecteur, est du domaine de l'invention. L'invention améliore considérablement la fiabilité de la partie électronique. Elle diminue les coûts de fabrication et les frais d'amortissement par une électronique de technologie standard dont seule l'application est spécifique, par rapport à la carte à puces classique dont l'électronique est spécifique et dans l'application et dans la technologie de fabrication.

**Revendications**

1. Système de connexion, avec un lecteur, d'une puce électronique maintenue dans un support d'enrobage (E) portable caractérisée en ce que cette puce est elle même contenue dans un boîter du type composant électronique (R) ayant des broches de sortie assemblables par un montage en surface, ce boîtier comportant à cet effet des broches (930) à poser et à souder sur des contacts métalliques (30) d'une surface supérieure (10) d'un moyen de connexion (MC), et en ce que ce système comporte un connecteur (8) pour connecter la puce au lecteur, le connecteur étant constitué par des contacts métalliques (50) d'une surface inférieure (11) du moyen de connexion (MC), des contacts métalliques (30) de la surface supérieure étant en vis-à-vis de et connectés à des contacts métalliques (50) de la surface inférieure et réciproquement, ce moyen de connexion étant maintenu à fleur dudit support d'enrobage.

2. Système selon la revendication 1, caractérisé en ce que les contacts métalliques (30) de la surface supérieure sont confondus avec les contacts métalliques (50) de la surface inférieure et constituent à eux seuls le moyen de connexion (MC) en faisant ainsi, côté surface supérieure (10), l'inter-connexion avec le composant électronique (2) et, côté surface inférieure (11), l'inter-connexion connecteur (8).

3. Système selon la revendication 1, caractérisé en ce que les contacts métalliques (30, 50) de la surface supérieure (10) et de la surface inférieure (11) du moyen de connexion (MC) sont gravés sur un côté et un côté opposé d'un support isolant (1), le moyen de connexion (MC) étant alors composé d'un support isolant (1) aux surfaces supérieures (10) et inférieures (11) et des contacts métalliques (30 et 50) sur ces surfaces.

4. Système selon l'une quelconque des revendications 2 ou 3, caractérisé en ce que les contacts métalliques se prolongent par des fils conducteurs (300, 400), pour réaliser ainsi une couche (901) d'un support d'interconnexion multi-couches (9), de manière à interconnecter avec le composant électronique (2) un ou plusieurs autres composants électroniques (92, 93).

5. Système selon la revendication 4, caractérisé en ce que ces autres composants électroniques (92, 93) sont aussi interconnectés entre eux.

6. Système selon l'une des revendications précédentes, caractérisé en ce que le composant électronique (2) comporte un boîtier (24) dans lequel sont intégrées une ou plusieurs puces de semi-conducteurs.

7. Système selon la revendication 2, caractérisé en ce que le composant électronique (2) et ses contacts métalliques (30,50) de connexion sont sertis par rivetage dans le support d'enrobage (E).

8. Système selon la revendication 7, caractérisé en ce que le support d'enrobage est dissipatif.

**Patentansprüche**

1. Mit einer Leseeinrichtung versehenes Verbindungssystem einer in einer Beschichtungsstütze (E) gehaltenen tragbaren elektronischen integrierten Schaltung, dadurch gekennzeichnet, daß die elektronische intergrierte Schaltung selbst in einem für elektronische Bauteile (2) geeigneten Kasten untergebracht ist, dessen Ausgangsstifte an der Oberfläche verbindbar sind, wobei der Kasten zu diesem Zweck in Stellung zu bringende Stifte (930) aufweist, die an metallischen Kontakten (30) einer oberen Fläche (10) einer Verbindungseinrichtung (MC) zu löten sind, und daß dieses System einen Verbinder (8) umfaßt, um die integrierte Schaltung mit der Leseeinrichtung zu verbinden, wobei der Verbinder metallische Kontakte (50) einer unteren Fläche (11) der Verbindungseinrichtung (MC) aufweist, wobei metallische Kontakte (30) der oberen Fläche metallischen Kontakte (50) der unteren Fläche gegenüberliegend angeordnet und mit diesen verbunden sind und umgekehrt, und wobei diese Verbindungseinrichtung so gehalten ist, daß sie mit der Beschichtungsstütze ausgefluchtet ist.

2. System nach Anspruch 1, dadurch gekennzeichnet, daß die metallischen Kontakte (30) der oberen Fläche mit den metallischen Kontakten (50) der unteren Fläche zusammengelegt sind und allein die Verbindungseinrichtung (MC) bilden, so daß sie im Bereich der oberen Fläche (10) die Verbindung mit dem elektronischen Bauteil (2) und im Bereich der unteren Fläche (11) die Verbindung mit dem Verbinder (8) bilden.

3. System nach Anspruch 1, dadurch gekennzeichnet, daß die metallischen Kontakte (30 und 50) im Bereich der oberen Fläche (10) und im Bereich der unteren Fläche (11) der Verbindungseinrichtung (MC) an der einen und an der entgegengesetzten Seite einer isolierenden Stütze (1) eingraviert sind, wobei die Verbindungseinrichtung (MC) dann aus einer isolierenden, obere (10) und untere (11), metallische Kontakte (30 und 50) tragende Fläche aufweisenden Stütze (1) besteht.

4. System nach einem der Ansprüche 2 und 3, dadurch gekennzeichnet, daß die metallische Kontakte in Form von leitenden Drähten (300 und 400) so verlängert werden, daß eine Schicht (901) eine Mehrschicht-Verbindungsstütze (9) gebildet wird, so daß ein oder mehrere andere elektronische Bauteile (92 und 93) mit dem elektronischen Bauteil (2) verbunden werden.

5. System nach Anspruch 4, dadurch gekennzeichnet, daß die anderen elektronischen Bauteile (92 und 93) auch untereinander verbunden sind.

6. System nach einem der vorhergehenden Ansprüche, dadurch gekennzeichnet, daß der elektronische Bauteil (2) einen Kasten (24) umfaßt, in dem ein oder mehrere integrierte halbleiterschaltungen integriert sind.

7. System nach Anspruch 2, dadurch gekennzeichnet, daß der elektronische Bauteil (2) und dessen metallische Verbindungskontakte (30 und 50) in der Beschichtungsstütze (E) durch Vernietung gehalten sind.

8. System nach Anspruch 7, dadurch gekennzeichnet, daß die Beschichtungsstütze eine ableitende Funktion hat.

**Claims**

1. A connection system, comprising a reader, of an electronic chip held in a portable covering support (E), characterized in that this chip is itself contained in a casing of the electronic component (2) type comprising output pins which can be connected by surface mounting, the casing comprising for this purpose connection pins (930) for placing and soldering on metallic contacts (30) of an upper surface (10) of a connection means (MC), and in th at the system comprises a connector (8) for connecting the chip to the reader, the connector being constituted by metallic contacts (50) of a lower surface (11) of the connection means (MC), metallic contacts (30) of the upper surface being opposite and connected to the metallic contacts (50) of the lower surface and vice versa, the connection means being held flush with the said covering support.

2. A system as claimed in claim 1, characterized in that the metallic contacts (30) of the upper surface (10) coincide with the metallic contacts (50) of the lower surface and themselves constitute the connection means (MC) by thus making, on the upper surface (10) side, the interconnection with the electronic component (2) and, on the lower surface (11) side, the interconnection with the connector (8).

3. A system as claimed in claim 1, characterized in that the metallic contacts (30, 50) of the upper surface (10) and the lower surface (11) of the connection means (MC) are etched on one side and on the opposite side of an insulating support (1), the connection means (MC) then being constituted by an insulating support (1) having upper (10) and lower (11) surfaces and comprising metallic contacts (30, 50) on these surfaces.

4. A system as claimed either in claim 2 or claim 3, characterized in that the metallic contacts are extended by conductive wires (300, 400) to form one layer (901) of a multi-layer interconnection support (9) so as to interconnect one or more other electronic components (92, 93) with the electronic component (2).

5. A system as claimed in claim 4, characterized in th at the other electronic components (92, 93) are also interconnected with one another.

6. A system as claimed in any one of the preceding claims, characterized in that the electronic component (2) comprises a casing (24) in which one or more semiconductor chips are integrated.

7. A system as claimed in claim 2, characterized in that the electronic component (2) and its metallic connection contacts (30, 50) are set by riveting in the covering support (E).

8. A system as claimed in claim 7, characterized in that the covering support is dissipative.

FIG_1-a

FIG_1-b

# FIG_1-c

Coupe a

Coupe b

Coupe c